# EUROPEAN PATENT SPECIFICATION

(11) **EP 3 030 056 B1**
(45) Date of publication and mention of the grant of the patent: **14.11.2018**
(21) Application number: 15195830.3
(22) Date of filing: 23.11.2015
(51) Int. Cl.: H05K 1/02, H05K 1/14

(54) **APPARATUS TO FORM A RADIUSED BEND IN A FLAT FLEXIBLE CABLE**
VORRICHTUNG ZUR BILDUNG EINER ABGERUNDETEN BIEGUNG IN EINEM FLACHEN FLEXIBLEN KABEL
APPAREIL POUR FORMER UNE COURBURE ARRONDIE DANS UN CÂBLE FLEXIBLE PLAT

(30) Priority: 03.12.2014 US 201414559057
(43) Date of publication of application: 08.06.2016
(73) Proprietor: Delphi Technologies, Inc., Troy, MI 48007 (US)
(72) Inventor: BLACKMER, Stephen, C, Millington, Michigan 48746 (US); LIBURDI, Steven, A., Grosse Pointe Farms, Michigan 48236 (US)
(74) Representative: Robert, Vincent

(56) References cited:
- JP-A- H04 311 091
- US-A- 6 166 332
- US-A1- 2001 002 145
- US-A1- 2002 051 349

## Description

### TECHNICAL FIELD OF INVENTION

This disclosure generally relates to an apparatus configured to shape a flat flexible cable (FFC) for installation onto a circuit board assembly, and more particularly relates to a radiused portion of the apparatus configured to determine or limit a minimum bend radius of the FFC when the FFC is installed into the apparatus.

### BACKGROUND OF INVENTION

Conventional ribbon cables that consist of many wires arranged in parallel and encapsulated in electrical insulation material are known. However, as the operating frequencies of electronic circuits increase, these conventional ribbon cables may not provide adequate impedance control and/or shielding for some applications. In response, the electrical interconnect industry has introduced impedance controlled flexible flat conductor (FFC) that overlays the simple ribbon cable with one or more layers of conductive material to provide the desired shielding and impedance requirements. Unfortunately, these layers make the FFC stiffer than the conventional ribbon cable, so the FFC may act as a spring when the FFC is formed or shaped to include, for example, a 180 degree bend in order to interconnect two adjacent and parallel oriented printed circuit boards (PCBs). The spring effect may make handling, bending, and connecting the FFC a challenge; and may apply a spring load between parts (e.g. adjacent PCBs) interconnected by the FFC, which may lift a printed circuit board (PCB) away from locator posts that are part of a circuit board assembly (CBA). One way to overcome the spring load effect is to form a crease in the FFC. However, this often causes the impedance of the FFC to increase to greater than a desired level, greater than 100 Ohms for example. Document US6166332A relates to a method and apparatus for bending ribbon cables.

### SUMMARY OF THE INVENTION

In accordance with one embodiment, an apparatus configured to shape a flat flexible cable (FFC) is provided. The apparatus is configured such that a first end and a second end of the FFC can be positioned, respectively, at a first location and a second location of a circuit board assembly (CBA). The apparatus includes a radiused portion configured to determine a bend radius of the FFC after the FFC is installed into the apparatus. The apparatus also includes a clamp portion configured to operate from an open position for installing the FFC into the apparatus to a clamped position. The clamp portion is coupled to a base portion of the apparatus by a flexible portion configured to urge the FFC against the radiused portion after the FFC is installed into the apparatus and the clamp portion is in the clamped position. The apparatus is a unitary embodiment.

Further features and advantages will appear more clearly on a reading of the following detailed description of the preferred embodiment, which is given by way of non-limiting example only and with reference to the accompanying drawings.

### BRIEF DESCRIPTION OF DRAWINGS

The present invention will now be described, by way of example with reference to the accompanying drawings, in which:
Fig. 1 is an apparatus with a flat flexible cable (FFC) installed and operated to form a bend in the FFC with a bend radius in accordance with one embodiment;
Fig. 2A is the apparatus of Fig. 1 prior to installing the FCC in accordance with one embodiment;
Fig. 2B is the apparatus of Fig. 1 after to installing the FCC but before bending the FCC in accordance with one embodiment;
Fig. 3 is a part of a circuit board assembly with the apparatus/FCC arrangement of Fig. 2B in accordance with one embodiment;
Fig. 4 is a circuit board assembly with the apparatus/FCC arrangement of Fig. 2B in accordance with one embodiment; and
Fig. 5 is the circuit board assembly with the apparatus/FCC arrangement of Fig. 1 in accordance with one embodiment.

### DETAILED DESCRIPTION

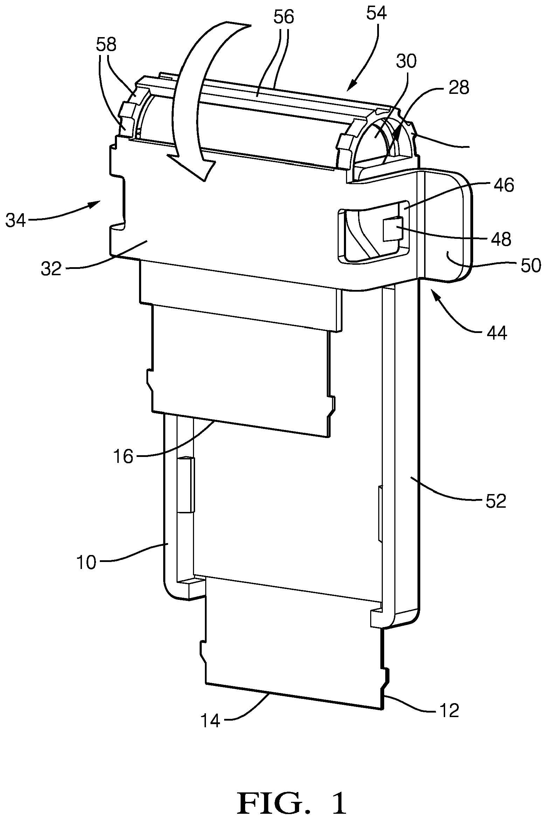

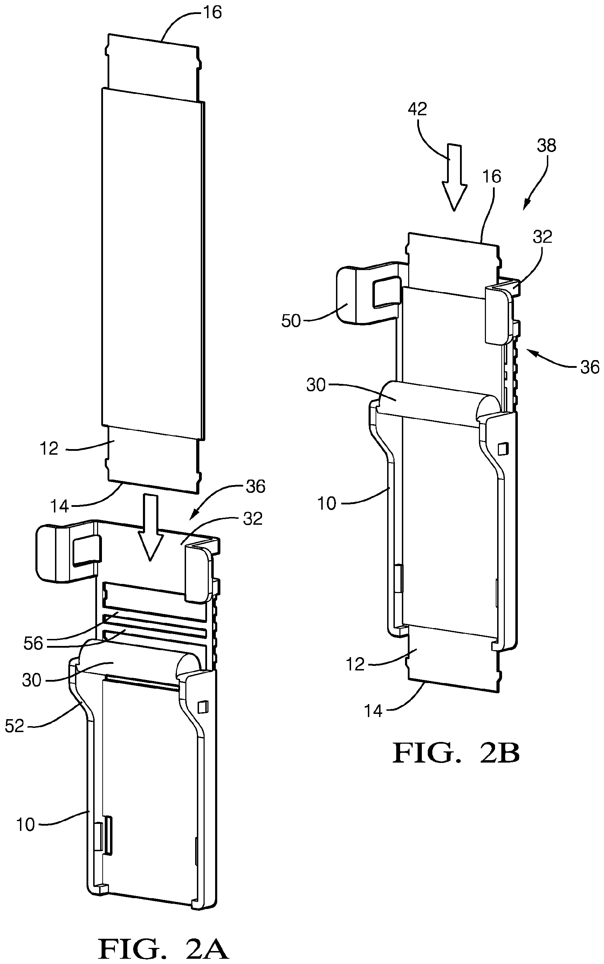

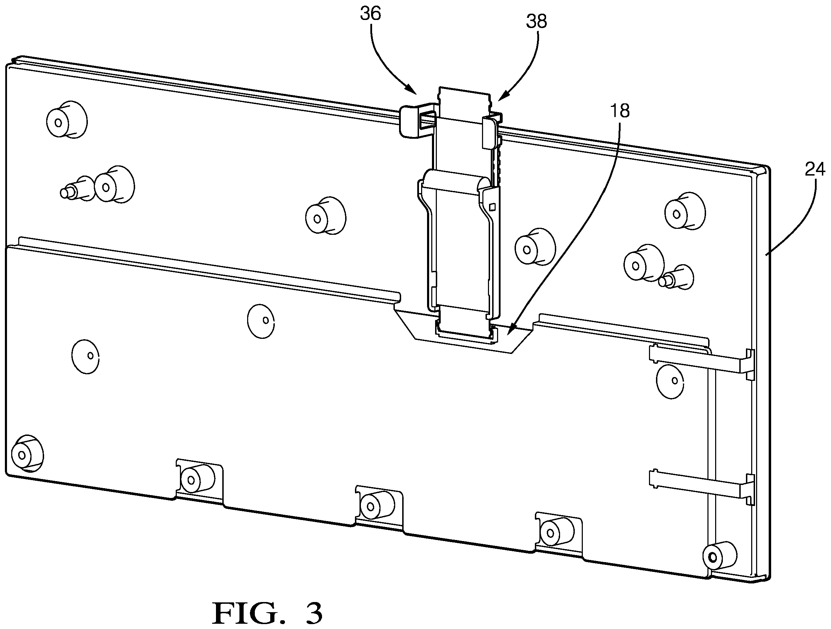

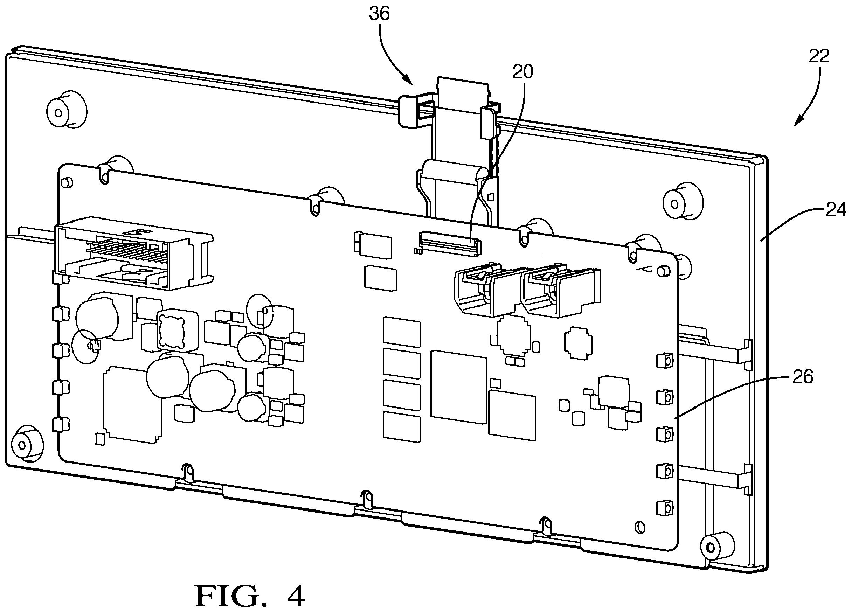

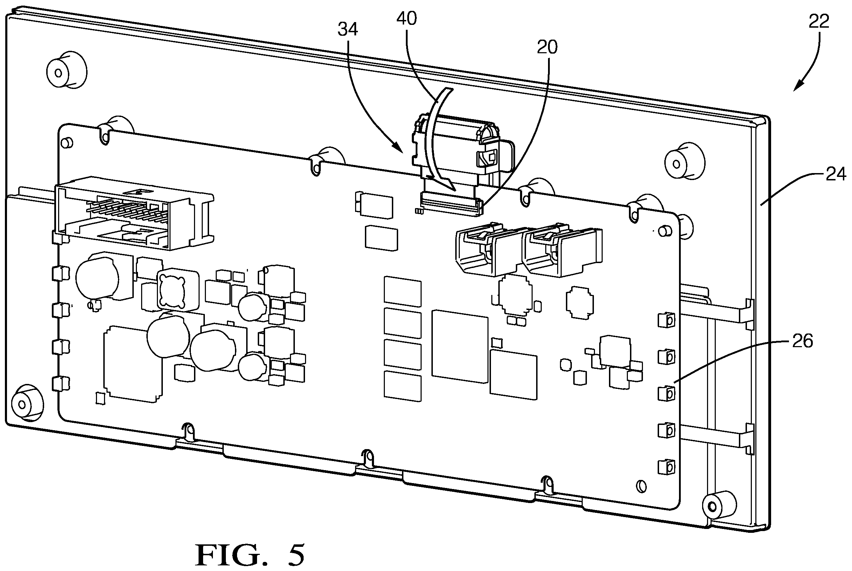

Figs. 1, 2A, and 2B illustrate a non-limiting example of an apparatus 10 and a flat flexible cable, hereafter the FFC 12. In general, the apparatus 10 is configured to shape the FFC 12 such that a first end 14 and a second end 16 of the FFC 12 can be positioned, respectively, at a first location 18 (Fig. 3) and a second location 20 (Figs. 4 and 5) of a circuit board assembly, hereafter the CBA 22. As will be explained in more detail below, the apparatus 10 is configured to form or bend the FFC 12 in a controlled manner so as to not cause a crease in the FFC 12. A crease is generally characterized as a bend with a radius that is too small and may cause an unacceptable change in the electrical impedance of the FFC 12. The apparatus is also configured to hold the FFC 12 in the shape formed by the apparatus 10 so the first end 14 and/or the second end 16 do not impart a spring force at the first location 18 and/or the second location 20 that may, for example, strain connections to, or force apart, a first printed circuit board, hereafter the first PCB 24 and a second circuit board, hereafter the second PCB 26, which make up the CBA 22.

Fig. 2A shows the apparatus 10 and the FFC 12 as separate parts before the FFC 12 is installed into the apparatus 10. By way of example and not limitation, a suitable example of the FFC 12 is a Shielded Flexible Flat Cable from Sumitomo Electric Interconnect Products of Singapore.

The apparatus 10 includes or defines a radiused portion 30 configured to determine a bend radius of the FFC 12 after the FFC 12 is installed into the apparatus 10. The apparatus 10 also includes or defines a clamp portion 32 configured to urge the FFC 12 around the radiused portion when the clamp portion 32 is operated from an open position 36 (Figs. 2A, 2B, 3, and 4) to a clamped position 34 (Figs. 1 and 5), whereby the FFC 12 is installed into the apparatus 10. By way of example and not limitation, the radiused portion 30 may have a radius 28 of five millimeters (5mm). As used herein, the FFC 12 is 'installed' into the apparatus 10 after the FFC 12 is inserted into the apparatus 10 as shown in Fig. 2B and the clamp portion 32 is operated to the clamped position 34 as shown in Figs. 1 and 5.

In one build scenario, the FFC 12 may be inserted into the apparatus 10 as indicated by arrow 42 in Fig. 2B to form an arrangement 38. The arrangement 38 may then be attached to the first PCB 24 as shown in Fig. 3. The attachment may be by way of an adhesive, or double-sided-tape, or pins (not shown) and/or fasteners (not shown) on the underside of the apparatus 10 cooperating with holes (not shown) in the first PCB 24. Then the second PCB 26 may be placed adjacent to the first PCB 24 as shown in Fig. 4, and the clamp portion 32 operated to the clamped position 34 as indicated by arrow 40 in Fig. 5. Alternatively, as shown in Fig. 1, the arrangement 38 shown in Fig. 2B may have the clamp portion 32 operated to the clamped position 34 prior to attaching the apparatus 10 with the FFC 12 already installed to the first PCB 24 with the second PCB 26 already located proximate to the first PCB 24. It is recognized that other sequences of steps may be suitable to assemble the CBA 22 shown in Fig. 5.

Referring again to Fig. 1, the apparatus 10 may include a latch 44 configured to hold or retain the clamp portion 32 in the clamped position 34 after the FFC 12 is installed into the apparatus 10. In this non-limiting example, the latch 44 includes an opening 46 that cooperates with a tang 48 to hold or retain the clamp portion 32 in the clamped position 34 once operated thereto. Those in the art will recognize that the function of the latch 44 could be provided by a wide variety of other features.

In order to provide something to grasp when operating the clamp portion 32, the apparatus 10 may be configured to define a tab 50 useful to urge the clamp portion 32 from the open position 36 toward a clamped position 34. The configuration of the tab 50 in this non-limiting example is advantageous as it limits how far the clamp portion 32 can be operated when the tab 50 contacts the first PCB, and thereby possibly preventing damaged to the FFC 12 by over-rotating the clamp portion 32.

The non-limiting example of the apparatus 10 presented herein is configured so the clamp portion 32 is coupled to a base portion 52 of the apparatus by a flexible portion 54 configured to urge the FCC 12 against the radiused portion 30 when the FFC 12 is installed into the apparatus 10. The flexible portion 54 may include an alternating pattern of ribs 56 that provide strength to press the FFC 12 toward the radiused portion 30, and thin sections 58 that provide for the flexibility of the flexible portion 54. A suitable material for a unitary embodiment of the apparatus 10 configured with the features described herein is an injection molding grade polypropylene available from a number of commercial sources, as will be recognized by those in the art.

Accordingly, an apparatus 10 configured to shape a flat flexible cable (the FFC 12) is provided. The apparatus 10 advantageously holds the FFC in the desire shape so that the FFC does not impart forces or strain onto the printed circuit boards of the CBA 22 or connectors mounted thereon. The shape imparted onto the FFC 12 is determined by a radiused portion 30 of the apparatus 10 which limits the radius formed into the FFC 12 to some minimum value so the FFC 12 is not damaged by a crease in the FFC 12. The apparatus 10 is also configured so an arrangement 38 of the FFC 12 and the apparatus 10 in the open position 36 can be installed onto the first PCB 24, and then the second PCB can be placed over the first PCB 24 and the arrangement 38 prior to operating the clamp portion 32 to the clamped position 34.

While this invention has been described in terms of the preferred embodiments thereof, it is not intended to be so limited, but rather only to the extent set forth in the claims that follow.

## Claims

1. An apparatus (10) configured to shape a flat flexible cable (FFC (12)) such that a first end (14) and a second end (16) of the FFC (12) can be positioned at a first location (18) and a second location (20) of a circuit board assembly (CBA (22)), said apparatus (10) comprising:
a radiused portion (30) configured to determine a bend radius (28) of the FFC (12) after the FFC (12) is installed into the apparatus (10); and
a clamp portion (32) configured to operate from an open position (36) for installing the FFC (12) into the apparatus (10) to a clamped position (34);
wherein the clamp portion (32) is coupled to a base portion (52) of the apparatus (10) by a flexible portion (54) configured to urge the FFC (12) against the radiused portion (30) after the FFC (12) is installed into the apparatus (10) and the clamp portion (32) is in the clamped position (34);
wherein the apparatus (10) is a unitary embodiment.

2. The apparatus (10) in accordance with claim 1, wherein the apparatus (10) includes a latch (44) configured to retain the clamp portion (32) in a clamped position (34) after the FFC (12) is installed into the apparatus (10).

3. The apparatus (10) in accordance with claim 1 or 2, wherein the apparatus (10) is configured to define a tab (50) useful to urge the clamp portion (32) from an open position (36) toward a clamped position (34).

## Patentansprüche

1. Vorrichtung (10), die konfiguriert ist zum Formen eines flachen flexiblen Kabels (FFC - flat flexible cable (12)) derart, dass ein erstes Ende (14) und ein zweites Ende (16) des FFC (12) an einer ersten Position (18) und an einer zweiten Position (20) einer Leiterplattenanordnung (CBA - circuit board assembly (22)) positioniert werden können, wobei die Vorrichtung (10) aufweist:
einen Radiusteil (30), der konfiguriert ist zum Bestimmen eines Biegeradius (28) des FFC (12), nachdem das FFC (12) in der Vorrichtung (10) installiert ist; und
einen Klemmteil (32), der konfiguriert ist für einen Betrieb von einer offenen Position (36) zum Installieren des FFC (12) in der Vorrichtung (10) zu einer geklemmten Position (34);
wobei der Klemmteil (32) mit einem Basisteil (52) der Vorrichtung (10) durch einen flexiblen Teil (54) gekoppelt ist, der konfiguriert ist zum Beeinflussen des FFC (12) gegen den Radiusteil (30), nachdem das FFC (12) in der Vorrichtung (10) installiert ist und der Klemmteil (32) in der geklemmten Position (34) ist;
wobei die Vorrichtung (10) ein unitäres Ausführungsbeispiel ist.

2. Die Vorrichtung (10) gemäß Anspruch 1, wobei die Vorrichtung (10) eine Verriegelung (44) umfasst, die konfiguriert ist, um den Klemmteil (32) in einer geklemmten Position (34) zu halten, nachdem das FFC (12) in der Vorrichtung (10) installiert ist.

3. Die Vorrichtung (10) gemäß Anspruch 1 oder 2, wobei die Vorrichtung (10) konfiguriert ist zum Definieren einer Lasche (50), die dazu dient, den Klemmteil (32) von einer offenen Position (36) in eine geklemmte Position (34) zu drücken.

## Revendications

1. Appareil (10) configuré pour conformer un câble flexible plat (CFP (12)) de telle façon qu'une première extrémité (14) et une seconde extrémité (16) du CFP (12) peuvent être positionnées à un premier emplacement (18) et un second emplacement (20) d'un ensemble formant carte à circuits (ECC (22)), ledit appareil (10) comprenant :
une portion arrondie (30) configurée pour déterminer un rayon de cintrage (28) du CFP (12) après avoir installé le CFP (12) dans l'appareil (10) ; et
une portion formant pince (32) configurée pour être actionnée depuis une position ouverte (36) pour installer le CFP (12) dans l'appareil (10) jusqu'à une position pincée (34) ;
dans lequel la portion formant pince (32) est couplée à une portion de base (52) de l'appareil (10) par une portion flexible (54) configurée pour forcer le CFP (12) contre la portion arrondie (30) après avoir installé le CFP (12) dans l'appareil (10) et que la portion formant pince (32) est dans la position pincée (34);
dans lequel l'appareil (10) est un mode de réalisation unitaire.

2. Appareil (10) selon la revendication 1, dans lequel l'appareil (10) inclut un verrou (44) configuré pour retenir la portion formant pince (32) dans une position pincée (34) après avoir installé le CFP (12) dans l'appareil (10).

3. Appareil (10) selon la revendication 1 ou 2, dans lequel l'appareil (10) est configuré pour définir une patte (50) utilisable pour forcer la portion formant pince (32) depuis une position ouverte (36) vers une position pincée (34).
